# EUROPEAN PATENT APPLICATION

(11) **EP 2 395 569 A2**
(43) Date of publication of application: **14.12.2011**
(21) Application number: 11169807.2
(22) Date of filing: 14.06.2011
(51) Int. Cl.: H01L 33/50, H01L 33/52, G02F 1/13357, H01L 33/48, H01L 33/54, H01L 33/58, F21K 99/00

(54) **Light Emitting Device Package Using Quantum Dot, Illumination Apparatus and Display Apparatus**

(30) Priority: 14.06.2010 US 354429 P; 20.10.2010 KR 20100102419
(71) Applicant: Samsung LED Co., Ltd., Gyunggi-do (KR)
(72) Inventor: Lee, Hyo Jin, Seoul (KR); Park, Il Woo, Gyunggi-do (KR); Kwak, Chang Hoon, Seoul (KR)
(74) Representative: Grünecker, Kinkeldey, Stockmair & Schwanhäusser

(57) **Abstract**

There is provided a light emitting device package (100) using a quantum dot, an illumination apparatus and a display apparatus. The light emitting device package (100) includes a light emitting device (101); a sealing part (104) disposed in a path of light emitted from the light emitting device and having a lens shape; and a wavelength conversion part (105) sealed within the sealing part (104) and including a quantum dot. The light emitting device package uses the quantum dot as the wavelength conversion part to thereby achieve superior color reproducibility and light emission efficiency, and facilitates the control of color coordinates by adjusting the particle size and concentration of the quantum dot.

## Description

### CROSS-REFERENCE TO RELATED APPLICATIONS

This application claims the priority of U.S. Provisional Application No. 61/354,429 filed on June 14, 2010 in the U.S. Patent and Trademark Office and the priority of Korean Patent Application No. 10-2010-0102419 filed on October 20, 2010 in the Korean Intellectual Property Office, the disclosures of which are incorporated herein by reference.

### BACKGROUND OF THE INVENTION

### Field of the Invention

The present invention relates to a light emitting device package using a quantum dot, an illumination apparatus and a display apparatus.

### Description of the Related Art

A quantum dot is a semiconductor nanocrystal having a diameter of approximately 10 nm or less and produces a quantum confinement effect. The quantum dot may emit light stronger than that emitted by a general phosphor within a narrow wavelength band. Light emission by the quantum dot may be implemented by the transfer of excited electrons from a conduction band to a valence band. Even in the case of a quantum dot of the same material, the quantum dot may emit light having different wavelengths according to a particle size thereof. As the size of the quantum dot is reduced, the quantum dot may emit short-wavelength light. Accordingly, light having a desired wavelength band may be obtained by adjusting the particle size of the quantum dot.

The quantum dot may be dispersed in an organic solvent by a coordinate bond. In a case in which the quantum dot is not properly dispersed or is exposed to oxygen or moisture, the light emission efficiency thereof may be reduced. In order to solve such a problem, the quantum dot has been encapsulated by organic matter. However, the capping of the quantum dot itself with organic matter or other materials having a relatively high band gap is problematic in terms of process and cost efficiency. Accordingly, demand for a method of using a quantum dot allowing for improved stability and light emission efficiency has increased. As an example of an attempt to meet this demand, an organic solvent, a polymer or the like having a quantum dot dispersed therein is injected into a polymer cell or a glass cell to thereby protect the quantum dot from exposure to oxygen or moisture.

### SUMMARY OF THE INVENTION

An aspect of the present invention provides a light emitting device package using a quantum dot stably, an illumination apparatus and a display apparatus.

According to an aspect of the present invention, there is provided a light emitting device package including: a light emitting device; a sealing part disposed in a path of light emitted from the light emitting device and having a lens shape; and a wavelength conversion part sealed within the sealing part and including a quantum dot.

The sealing part may have an outer surface and an inner surface facing the light emitting device, and the outer and inner surfaces may have a convex shape towards an upper part of the light emitting device.

The light emitting device may be disposed to be enclosed by the inner surface having the convex shape.

The light emitting device package may further include a transparent encapsulation part filling a space defined by the inner surface of the sealing part.

The light emitting device package may further include a pair of lead frames, and one of the pair of lead frames may be provided as a mounting area for the light emitting device.

The light emitting device package may further include a pair of conductive wires electrically connecting the light emitting device to the pair of lead frames, and the pair of conductive wires may be disposed to be enclosed by the inner surface having the convex shape.

The light emitting device package may further include a package body providing a mounting area for the light emitting device and reflecting the light emitted from the light emitting device in a direction in which the sealing part is disposed.

The package body may include a transparent resin and light reflective particles dispersed in the transparent resin.

The light emitting device package may further include a conductive wire transferring an electrical signal to the light emitting device, and a portion of the conductive wire may be disposed within the package body.

The light emitting device package may further include a pair of external terminals extending from side surfaces of the package body to a lower surface thereof and electrically connected to the light emitting device.

The sealing part may be formed of a glass or polymer material.

The wavelength conversion part may further include an organic solvent or a polymer resin having the quantum dot dispersed therein.

The organic solvent may include at least one of toluene, chloroform and ethanol.

The polymer resin may include at least one of epoxy resin, silicone resin, polysthylene resin and acrylate resin.

The quantum dot may include at least one of an Si-based nanocrystal, a group II-VI compound semiconductor nanocrystal, a group III-V compound semiconductor nanocrystal, a group IV-VI compound semiconductor nanocrystal or a mixture thereof.

The group II-VI compound semiconductor nanocrystal may be selected from the group consisting of CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HggZnTe, CdZnSeS, CdZnSeTe, CdZnSTe, CdHgSeS, CdHgSeTe, CdHgSTe, HgZnSeS, HgZnSeTe and HgZnSTe.

The group III-V compound semiconductor nanocrystal may be selected from the group consisting of GaN, GaP, GaAs, AlN, AlP, AlAs, InN, InP, InAs, GaNP, GaNAs, GaPAs, AlNP, AlNAs, AlPAs, InNP, InNAs, InPAs, GaAlNP, GaAlNAs, GaAlPAs, GaInNP, GaInNAs, GaInPAs, InAlNP, InAlNAs, and InAlPAs.

The group IV-VI compound semiconductor nanocrystal may be SbTe.

The quantum dot may include a first quantum dot having a peak wavelength within a green light wavelength band.

The quantum dot may include a second quantum dot having a peak wavelength within a red light wavelength band.

The light emitting device may emit blue light, and the quantum dot may include a first quantum dot having a peak wavelength within a green light wavelength band and a second quantum dot having a peak wavelength within a red light wavelength band.

The light emitted from the light emitting device may have a wavelength of 435 nm to 470 nm, green light emitted from the first quantum dot may have a color coordinate falling within a region defined by four coordinate points (0.1270, 0.8037), (0.4117, 0.5861), (0.4197, 0.5316) and (0.2555, 0.5030) based on the CIE 1931 chromaticity diagram, and red light emitted from the second quantum dot may have a color coordinate falling within a region defined by four coordinate points (0.5448, 0.4544), (0.7200, 0.2800), (0.6427, 0.2905) and (0.4794, 0.4633) based on the CIE 1931 chromaticity diagram.

Green light emitted from the first quantum dot may have a color coordinate falling within a region defined by four coordinate points (0.1270, 0.8037), (0.3700, 0.6180), (0.3700, 0.5800) and (0.2500, 0.5500) based on the CIE 1931 chromaticity diagram, and red light emitted from the second quantum dot may have a color coordinate falling within a region defined by four coordinate points (0.6000, 0.4000), (0.7200, 0.2800), (0.6427, 0.2905) and (0.6000, 0.4000) based on the CIE 1931 chromaticity diagram.

The light emitted from the light emitting device may have a full-width half-maximum of 10 nm to 30 nm, light emitted from the first quantum dot may have a full-width half-maximum of 10 nm to 60 nm, and light emitted from the second quantum dot may have a full-width half-maximum of 30 nm to 80 nm.

The light emitting device may emit ultraviolet light, and the quantum dot may include a first quantum dot having a peak wavelength within a blue light wavelength band, a second quantum dot having a peak wavelength within a green light wavelength band and a third quantum dot having a peak wavelength within a red light wavelength band.

According to another aspect of the present invention, there is provided a light emitting device package including: a light emitting device; a sealing part attached to a surface of the light emitting device; a wavelength conversion part sealed within the sealing part and including a quantum dot; and a pair of electrodes disposed on the light emitting device to be opposed to the sealing part.

The light emitting device package may further include a package body covering surfaces of the light emitting device other than the surface of the light emitting device attached to the sealing part and reflecting light emitted from the light emitting device in a direction in which the sealing part is disposed.

The package body may include a transparent resin and light reflective particles dispersed in the transparent resin.

The package body may allow a pair of electrodes to be exposed outwardly.

The sealing part may have a convex lens shape or a rectangular parallelepiped shape.

The wavelength conversion part may have a shape corresponding to that of the sealing part.

The light emitting device may include a plurality of light emitting devices, each having the pair of electrodes.

The sealing part and the wavelength conversion part may be integrally formed as a single piece with respect to the plurality of light emitting devices.

The light emitting device package may further include a package body covering surfaces of each of the plurality of light emitting devices other than the surface of the light emitting device attached to the sealing part and reflecting light emitted from the light emitting device in a direction in which the sealing part is disposed. The light emitting device package may further include external terminals provided along a surface of the package body and connected to the pair of electrodes.

According to another aspect of the present invention, there is provided an illumination apparatus including: the light emitting device package as described above; and a power supply unit supplying power to the light emitting device package.

The power supply unit may include an interface receiving the power; and a power controlling part controlling the power supplied to the light emitting device package.

According to another aspect of the present invention, there is provided a display apparatus including: the light emitting device package as described above; and a display panel displaying an image and receiving light emitted from the light emitting device package.

### BRIEF DESCRIPTION OF THE DRAWINGS

The above and other aspects, features and other advantages of the present invention will be more clearly understood from the following detailed description taken in conjunction with the accompanying drawings, in which:
FIG. 1 is a schematic cross-sectional view of a light emitting device package according to an embodiment of the present invention;
FIG. 2 is a schematic cross-sectional view of a light emitting device package according to another embodiment of the present invention;
FIGS. 3 and 4 are schematic cross-sectional views illustrating a method of manufacturing the light emitting device package of FIG. 1;
FIGS. 5 through 8 are schematic cross-sectional views illustrating a method of manufacturing the light emitting device package of FIG. 2;
FIGS. 9 through 13 are schematic cross-sectional views illustrating a method of manufacturing a light emitting device package according to another embodiment of the present invention;
FIGS. 14 through 17 are schematic cross-sectional views illustrating a method of manufacturing a light emitting device package according to another embodiment of the present invention;
FIGS. 18 through 20 are schematic cross-sectional views of light emitting device packages according to another embodiment of the present invention;
FIG. 21 is a graph showing the intensity of light according to a wavelength band of light emitted from a light emitting device package according to an embodiment of the present invention;
FIG. 22 is a chromaticity diagram showing the color coordinates of light emitted from a light emitting device package according to an embodiment of the present invention; and
FIG. 23 is a schematic view illustrating an example of the configuration of a light emitting device package according to an embodiment of the present invention.

### DETAILED DESCRIPTION OF THE INVENTION

Embodiments of the present invention will now be described in detail with reference to the accompanying drawings.

The invention may, however, be embodied in many different forms and should not be construed as being limited to the embodiments set forth herein. Rather, these embodiments are provided so that this disclosure will be thorough and complete, and will fully convey the scope of the invention to those skilled in the art.

In the drawings, the shapes and dimensions of elements may be exaggerated for clarity, and the same reference numerals will be used throughout to designate the same or like elements.

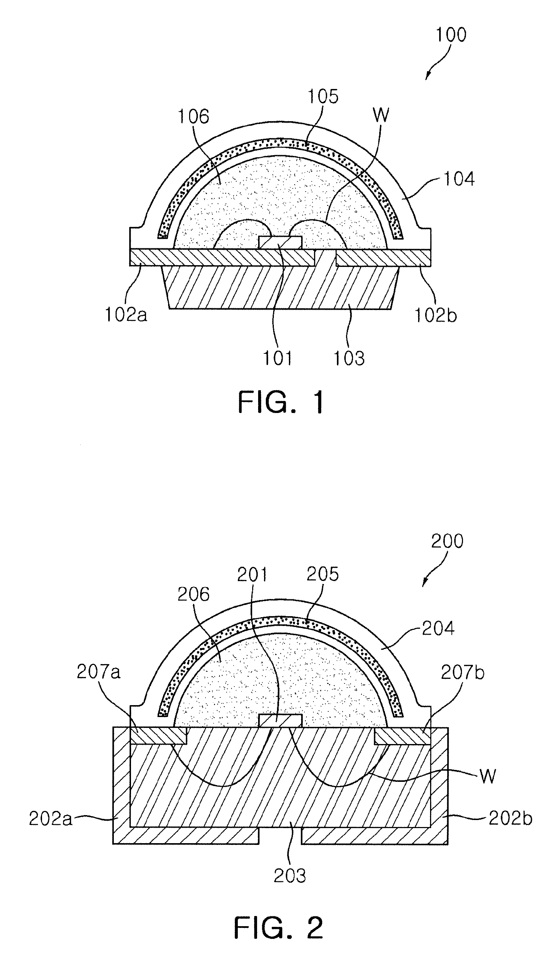

FIG. 1 is a schematic cross-sectional view of a light emitting device package according to an embodiment of the present invention. With reference to FIG. 1, a light emitting device package 100 according to this embodiment of the invention may include a light emitting device 101, a pair of lead frames 102a and 102b, a package body 103, a sealing part 104 having a lens shape, a wavelength conversion part 105, and a transparent encapsulation part 106. The light emitting device 101 may employ a photoelectric device emitting light when an electrical signal is applied thereto. A light emitting diode (LED) chip may be a representative light emitting device. For example, a GaN-based LED chip emitting blue light may be used therefor. At least part of the blue light may be converted into light of a different color by the wavelength conversion part 105, as will be described below.

The pair of lead frames 102a and 102b may be electrically connected to the light emitting device 101 by a pair of conductive wires W and may be used as terminals for the application of external electrical signals. To this end, the pair of lead frames 102a and 102b may be formed of a metal having superior electrical conductivity. As shown in FIG. 1, one of the pair of lead frames 102a and 102b may be provided as a mounting area for the light emitting device 101. In the present embodiment, a pair of electrodes (not shown) connected to the light emitting device 101 are disposed on an upper portion of the light emitting device 101 in a direction in which the sealing part 104 is disposed, and the light emitting device 101 is connected to the pair of lead frames 102a and 102b using the pair of conductive wires W. However, the connection method thereof may be varied according to embodiments of the invention. For example, the light emitting device 101 may be directly electrically connected to one lead frame 102a provided as the mounting area thereof without using the wire, while being connected to the other lead frame 102b using the wire. As another example, the light emitting device 101 may be disposed in a flip-chip bonding manner without the conductive wires W. Meanwhile, a single light emitting device is provided in the present embodiment; however, two or more light emitting devices may be provided. Furthermore, a conductive wire is used as an example of a wiring structure; however, it may be replaced with various types of wiring structure, e.g., a metal line, so long as electrical signals may be transferred therethrough.

The package body 103 may be disposed to be opposed to the sealing part 104 with relation to the light emitting device 101, and may serve to fix the pair of lead frames 102a and 102b. The package body 103 may be formed of a material having electrical insulation while being superior in thermal emissivity and light reflectivity properties; however, the material of the package body 103 is not particularly limited thereto. In light of this, the package body 103 may be formed of a transparent resin and have a structure in which light reflective particles, e.g., TiO₂, are dispersed in the transparent resin.

In the present embodiment, the sealing part 104 may be disposed above the light emitting device 101 in a path of light emitted from the light emitting device 101 and have a convex lens shape. Specifically, the sealing part 104 has an outer surface and an inner surface facing the light emitting device 101, and the outer and inner surfaces may have a convex shape towards the upper part of the light emitting device 101. In this case, as shown in FIG. 1, the light emitting device 101 and the conductive wires W may be disposed to be enclosed by the inner surface having the convex shape. The encapsulation part 106 formed of a silicone resin or the like may be provided in a space defined by the inner surface of the sealing part 104. The encapsulation part 106 may protect the light emitting device 101 and the conductive wires W and allow for refraction index matching with the material of the light emitting device 101. The encapsulation part 106 is not indispensable, so it may be omitted according to embodiments of the invention.

The wavelength conversion part 105 is sealed within the sealing part 104 and includes a quantum dot. To this end, the sealing part 104 may be formed of a glass or transparent polymer material which is suitable for protecting the quantum dot from exposure to oxygen or moisture. Here, the wavelength conversion part 105 may have a shape corresponding to that of the sealing part 104, which is not necessarily required. The quantum dot is a semiconductor nanocrystal having a diameter of approximately 1 nm to 10 nm and represents a quantum confinement effect. The quantum dot converts the wavelength of light emitted from the light emitting device 101 to thereby generate wavelength-converted light, i.e., fluorescent light. For example, the quantum dot may be a nanocrystal such as an Si-based nanocrystal, a group II-VI compound semiconductor nanocrystal, a group III-V compound semiconductor nanocrystal, a group IV-VI compound semiconductor nanocrystal or the like. The preceding examples of the quantum dot may be used individually or combined in the present embodiment.

More specifically, the group II-VI compound semiconductor nanocrystal may be selected from the group consisting of CdS, CdSe, CdTe, ZnS, ZnSe, ZnTe, HgS, HgSe, HgTe, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HggZnTe, CdZnSeS, CdZnSeTe, CdZnSTe, CdHgSeS, CdHgSeTe, CdHgSTe, HgZnSeS, HgZnSeTe and HgZnSTe. The group III-V compound semiconductor nanocrystal may be selected from the group consisting of GaN, GaP, GaAs, AlN, AlP, AlAs, InN, InP, InAs, GaNP, GaNAs, GaPAs, AlNP, AlNAs, AlPAs, InNP, InNAs, InPAs, GaAlNP, GaAlNAs, GaAlPAs, GaInNP, GaInNAs, GaInPAs, InAlNP, InAlNAs, and InAlPAs. The group IV-VI compound semiconductor nanocrystal may be SbTe.

The quantum dot may be dispersed in a dispersion medium such as an organic solvent or a polymer resin by a coordinate bond. As described above, the wavelength conversion part 105 having such a structure is sealed within the sealing part 104. Here, the dispersion medium may employ a transparent medium having no influence on the wavelength conversion function of the quantum dot while allowing for no degeneration change in quality and no reflection and absorption of light. For example, the organic solvent may include at least one of toluene, chloroform and ethanol, and the polymer resin may include at least one of epoxy resin, silicone resin, polysthylene resin and acrylate resin. In a case in which the polymer resin is used as the dispersion medium, the polymer resin having the quantum dot dispersed therein may be injected into the sealing part 104 and then hardened.

Meanwhile, light emission in the quantum dot may be implemented by the transfer of excited electrons from a conduction band to a valence band. Even in the case of a quantum dot of the same material, the quantum dot may emit light having different wavelengths according to a particle size thereof. As the size of the quantum dot is reduced, the quantum dot may emit short-wavelength light. Light having a desired wavelength band may be obtained by adjusting the size of the quantum dot. Here, the size of the quantum dot may be adjusted by appropriately changing the growth conditions of nanocrystals.

As described above, the light emitting device 101 may emit blue light, more particularly, light having a dominant wavelength of approximately 435 nm to 470 nm. In this case, the quantum dot may include a first quantum dot having a peak wavelength within a green light wavelength band and a second quantum dot having a peak wavelength within a red light wavelength band. Here, the sizes of the first and second quantum dots may be appropriately adjusted to cause the first quantum dot to have a peak wavelength of approximately 500 nm to 550 nm and cause the second quantum dot to have a peak wavelength of approximately 580 nm to 660 nm. Meanwhile, the quantum dot may emit light stronger than that emitted by a general phosphor within a narrow wavelength band. Accordingly, in the quantum dot according to the present embodiment, the first quantum dot may have a full-width half-maximum (FWHM) of approximately 10 nm to 60 nm and the second quantum dot may have a full-width half-maximum (FWHM) of approximately 30 nm to 80 nm. In this case, the light emitting device 101 may employ a blue LED chip having a full-width half-maximum (FWHM) of approximately 10 nm to 30 nm.

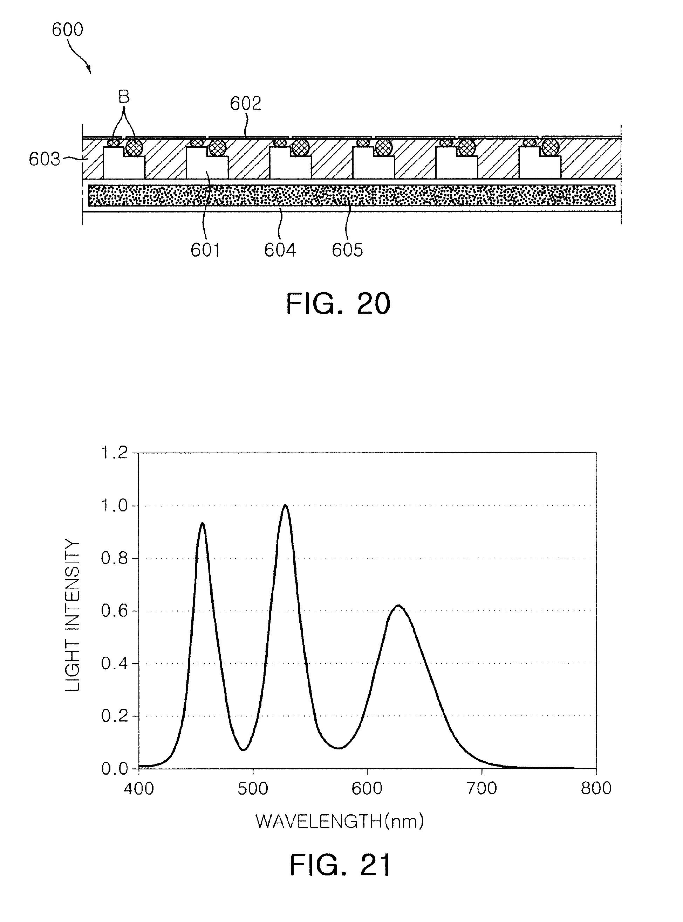

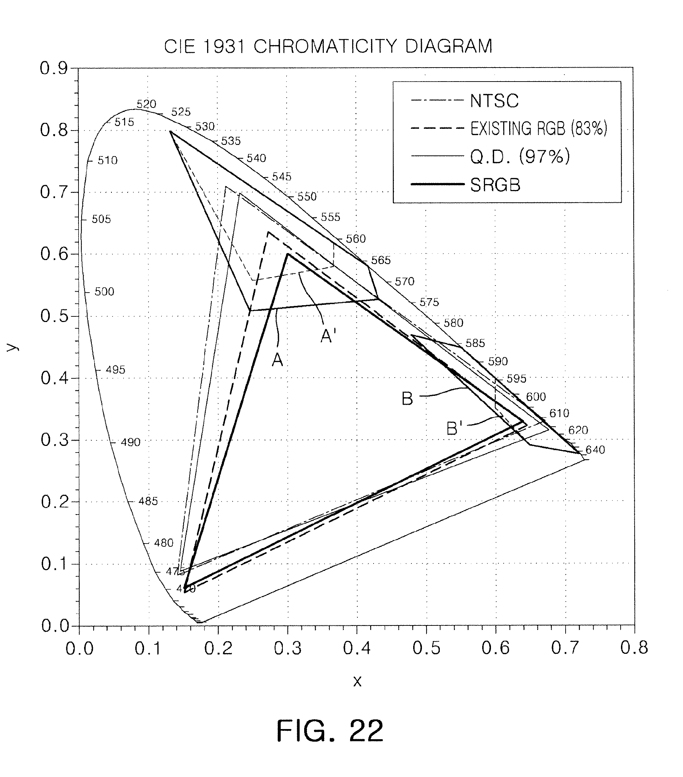

FIG. 21 is a graph showing the intensity of light according to a wavelength band of light emitted from a light emitting device package according to an embodiment of the present invention. FIG. 22 is a chromaticity diagram showing the color coordinates of light emitted from a light emitting device package according to an embodiment of the present invention.

According to the present embodiment, as described above, the wavelength band of light may be controlled by adjusting the particle size of a quantum dot provided in a light emitting device package. For example, the wavelength band may be controlled to represent the characteristics described in Table 1.

**[Table 1]**

| | Blue | Green | Red |
|---|---|---|---|
| Wp (nm) | 455 | 535 | 630 |
| FWHM (nm) | 20 | 30 | 54 |

In Table 1, Wp refers to the dominant wavelength of blue, green and red light, and FWHM refers to the full-width half-maximum of blue, green and red light. With reference to Table 1, blue light is emitted from the light emitting device 101, and green and red light are emitted from the quantum dot. The blue, green and red light may have a light intensity distribution as shown in FIG. 21. In addition, the particle size of the quantum dot being used may be adjusted to thereby control a wavelength band, and the concentration of the quantum dot according to the particle size thereof may be adjusted to thereby control color coordinates. Accordingly, as shown in FIG. 22, the particle size and concentration of the quantum dot may be adjusted such that the green light emitted from the first quantum dot has a color coordinate falling within a region A defined by four coordinate points (0.1270, 0.8037), (0.4117, 0.5861), (0.4197, 0.5316) and (0.2555, 0.5030) based on the CIE 1931 chromaticity diagram, and the red light emitted from the second quantum dot has a color coordinate falling within a region B defined by four coordinate points (0.5448, 0.4544), (0.7200, 0.2800), (0.6427, 0.2905) and (0.4794, 0.4633) based on the CIE 1931 chromaticity diagram. The light emitting device package having such a distribution, as shown in FIG. 22, covers a relatively wide region as compared to a product using an existing phosphor and represents a color reproducibility of 95% or greater based on the NTSC standard and very high light intensity.

As described above, since the quantum dot emits light stronger than that emitted from a general phosphor within a narrow wavelength band, the first and second quantum dots may have a color coordinate falling within a further narrow region. That is, the green light emitted from the first quantum dot has a color coordinate falling within a region A' defined by four coordinate points (0.1270, 0.8037), (0.3700, 0.6180), (0.3700, 0.5800) and (0.2500, 0.5500) based on the CIE 1931 chromaticity diagram, and the red light emitted from the second quantum dot has a color coordinate falling within a region B' defined by four coordinate points (0.6000, 0.4000), (0.7200, 0.2800), (0.6427, 0.2905) and (0.6000, 0.4000) based on the CIE 1931 chromaticity diagram, and thus color reproducibility may be further enhanced. The light emitting device package 100 according to the present embodiment may cause the light emitting device 101 to have a dominant wavelength within a specific range and cause the first and second quantum dots to have color coordinates (based on the CIE 1931 chromaticity diagram) falling within specific regions, thereby improving color reproducibility by a combination of the light emitting device 101 and the first and second quantum dots.

Meanwhile, the above-described light emitting device package 100 may employ a blue LED chip as the light emitting device 101 and quantum dots converting the wavelength of blue light to thereby generate red and green light; however, the invention is not limited thereto. For example, the light emitting device 101 may be an ultraviolet LED chip, and the particle size and concentration of quantum dots may be adjusted, the quantum dots including a first quantum dot having a peak wavelength within a blue light wavelength band, a second quantum dot having a peak wavelength within a green light wavelength band and a third quantum dot having a peak wavelength within a red light wavelength band. In this case, the light emitting device 101, i.e., the ultraviolet LED chip may serve as a light source for the excitation of the wavelength conversion part 105 emitting white light.

In the case of the use of a light emitting module having the plurality of light emitting device packages 100 mounted therein, each light emitting device package 100 including the wavelength conversion part 105 having the quantum dot sealed therein, high reliability may be expected. In addition, since the wavelength conversion part 105 and the sealing part 104 are provided in a lens shape to thereby appropriately adjust the orientation angle of light, light emission efficiency may be enhanced. On the contrary, in a case in which a wavelength conversion part having a quantum dot is integrally formed as a single piece with respect to a plurality of light emitting devices, if a portion of a sealing part is defective, the reliability of the overall module may be deteriorated and it would be difficult to adjust the orientation angle of light by changing the shapes of the wavelength conversion part and the sealing part.

FIG. 2 is a schematic cross-sectional view of a light emitting device package according to another embodiment of the present invention. With reference to FIG. 2, a light emitting device package 200 according to the present embodiment may include a light emitting device 201, a pair of external terminals 202a and 202b, a package body 203, a sealing part 204 having a lens shape, a wavelength conversion part 205, and a transparent encapsulation part 206. Elements defined by the same terms will be understood as being the same elements as described in the previous embodiment. Hereinafter, different elements will be mainly described in detail.

In the present embodiment, the light emitting device 201 may be disposed on the package body 203, and a pair of electrodes (not shown) connected to the light emitting device 201 may be disposed on a lower portion of the light emitting device 201, unlike the previous embodiment, that is, to be opposed to the sealing part 204. Accordingly, as shown in FIG. 2, a pair of conductive wires W may have a structure in which at least a portion thereof is buried in the package body 203. In this manner, the conductive wires W are not disposed in a path of emitted light, thereby minimizing degradation in light emission efficiency that may be caused by the conductive wires W. The pair of external terminals 202a and 202b, applying an electrical signal to the light emitting device 201, may extend from side surfaces of the package body 203 to a lower surface thereof. In this case, a pair of connection parts 207a and 207b, which are not indispensable, may be further provided in order to connect the conductive wires W to the external terminals 202a and 202b.

According to the present embodiment, like the preceding embodiment of FIG. 1, in a case in which a light emitting module having the plurality of light emitting device packages 200 mounted therein is used, high reliability may be expected. In addition, the wavelength conversion part 205 and the sealing part 204 are provided in a lens shape to thereby appropriately adjust the orientation angle of light, so that light emission efficiency may be enhanced. Furthermore, the light emitting device 201 may have a material having high reflectivity (e.g., TiO₂) on the lower portion thereof, and thus the light emission efficiency thereof may be enhanced. In this case, a silicone resin is used as a transparent resin having light reflective particles such as TiO₂ dispersed therein, whereby the reliability of the light emitting device package may be improved even in high temperature and high humidity conditions.

Hereinafter, a method of manufacturing the light emitting device package of FIGS. 1 and 2 will be described in detail.

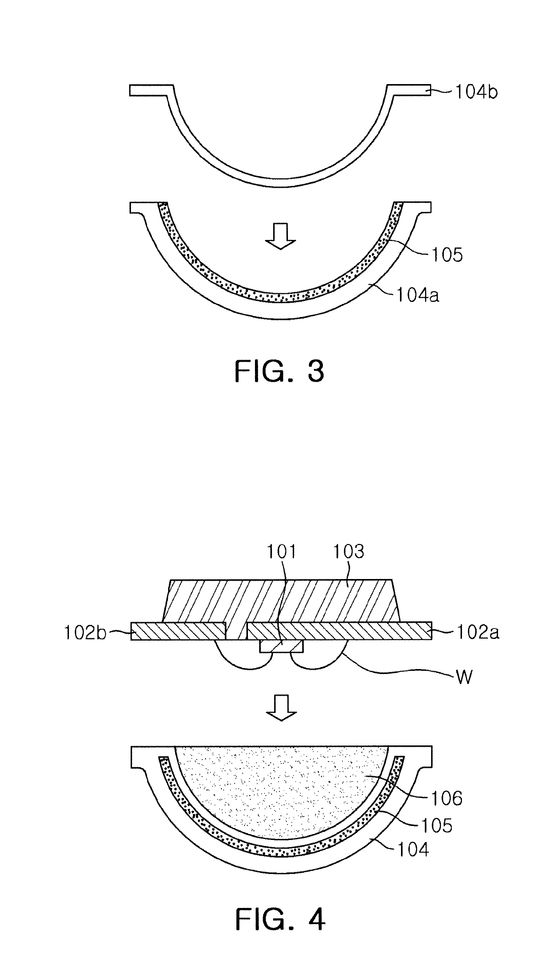

FIGS. 3 and 4 are schematic cross-sectional views illustrating a method of manufacturing the light emitting device package of FIG. 1. As shown in FIG. 3, as an example of a method of forming the sealing part 104 having the wavelength conversion part 105 sealed therein, the wavelength conversion part 105 containing a quantum dot and a dispersion medium for the dispersion of the quantum dot may be formed along an inner wall of a first transparent portion 104a. Thereafter, the first transparent portion 104a and a second transparent portion 104b having a shape corresponding to that of the first transparent portion 104a are pressed to thereby allow the wavelength conversion part 105 to be sealed therebetween. Then, as shown in FIG. 4, the transparent encapsulation part 106 is formed in a space formed by the inner surface of the sealing part 104 using a silicone resin or the like, and it is combined with the light emitting device 101. In terms of process efficiency, after the other elements of the light emitting device package, that is, the lead frames 102a and 102b, the package body 103, the conductive wires W and the like are all formed, they may be combined with the sealing part 104 in an inverted manner.

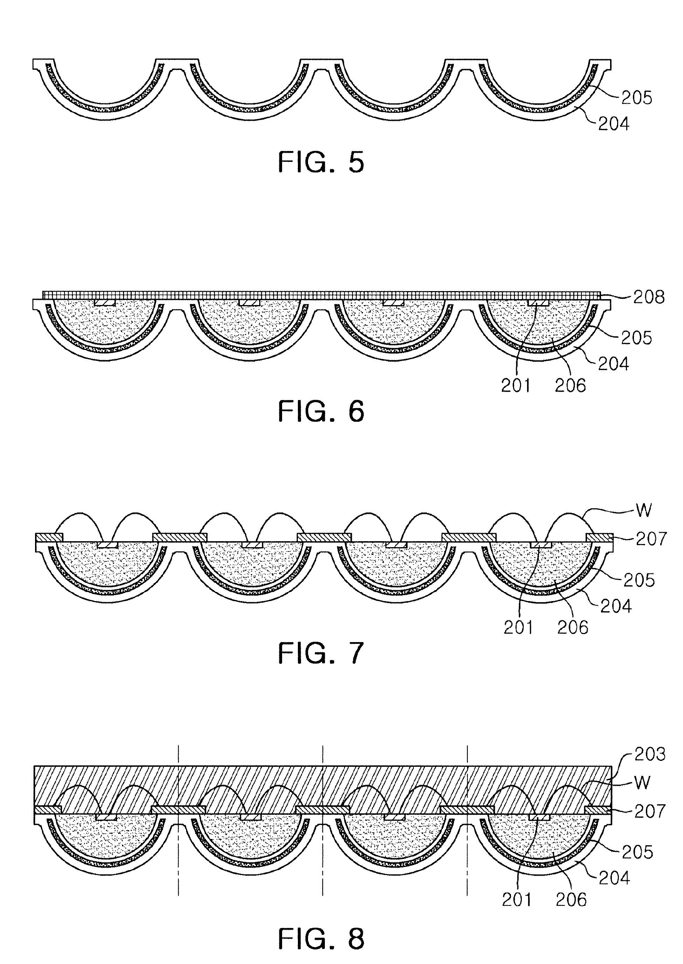

FIGS. 5 through 8 are schematic cross-sectional views illustrating a method of manufacturing the light emitting device package of FIG. 2. In the present embodiment, a method of manufacturing the plurality of light emitting device packages will be described. First of all, as shown in FIG. 5, the sealing parts 204 are formed to seal the respective wavelength conversion parts 205 therein using the method described in the embodiment of FIG. 3, except that the sealing parts 204 are provided in an array form. Next, as shown in FIG. 6, the transparent encapsulation parts 206 are formed to fill spaces defined by the inner surfaces of the sealing parts 204 and they are combined with the light emitting devices 201. In the present embodiment, the combination of the light emitting devices 201 and the transparent encapsulation parts 206 may be performed in a state in which the plurality of light emitting devices 201 are attached to a carrier sheet 208. The carrier sheet 208 may be a polymer film or the like to which the light emitting devices 201 are attachable.

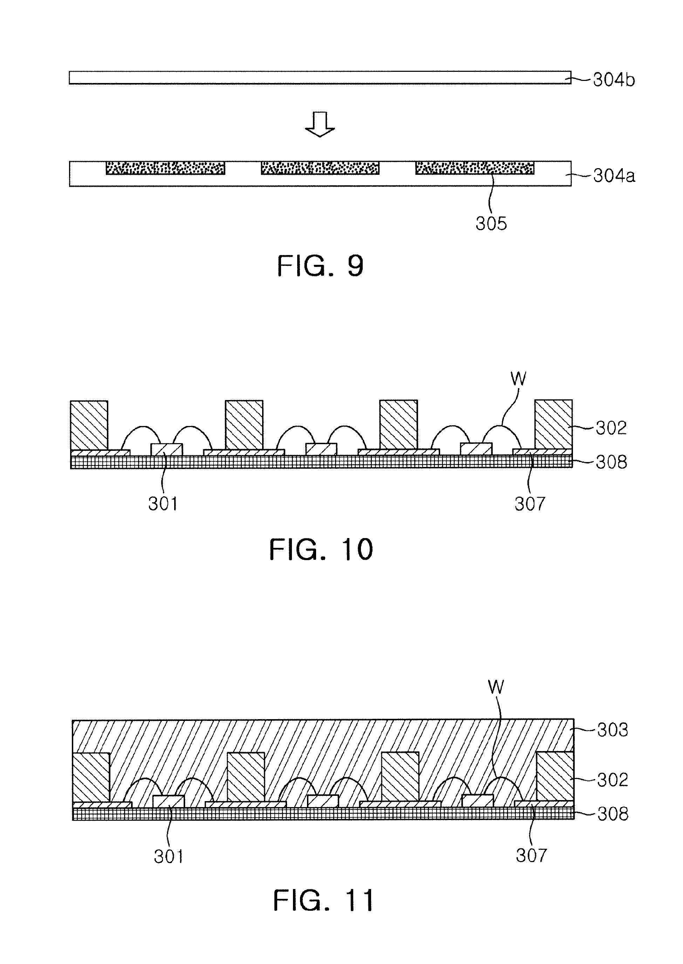

Thereafter, the carrier sheet 208 is separated from the light emitting devices 201 to thereby allow the light emitting devices 201 to be exposed. The conductive wires W are formed to make connections with the pair of electrodes (not shown) formed on the exposed surfaces of the light emitting devices 201. In this case, the conductive wires W may be connected to the connection parts 207 formed on the surfaces of the sealing parts 204. As described above, the connection parts 207 may be provided for making connections with the external terminals; however, they may be omitted according to embodiments of the invention. Then, as shown in FIG. 8, the package body 203 may be formed such that it is combined with the sealing parts 204 and covers the light emitting devices 201 and the conductive wires W. The package body 203 may have a structure in which light reflective particles, e.g., TiO₂, are dispersed in a transparent resin and serve to reflect light emitted from the light emitting devices 201 in a direction in which the sealing parts 204 are disposed. After the formation of the package body 203, a dicing process is performed to form individual light emitting device packages. Although not shown, with respect to each of the divided light emitting device packages, the external terminals may be formed on the side and lower surfaces of the package body 203 to thereby form the structure shown in FIG. 2. The formation of the external terminals of the light emitting device packages may be performed after the dicing process as described in the present embodiment or prior to the dicing process as will be described below with reference to FIGS. 9 through 13.

As described in FIG. 9, a sealing part 304 is formed to have a structure in which a wavelength conversion part 305 is sealed within the sealing part 304 using the above-described method, that is, the wavelength conversion part 305 is formed in a first transparent portion 304a and a second transparent portion 304b is attached thereto by a pressing process. In the present embodiment, the sealing part 304 may have a rectangular parallelepiped shape rather than a convex lens shape, which illustrates that the sealing part 304 may be modified to have various shapes. Since the sealing part 304 has the rectangular parallelepiped shape, the transparent encapsulation part described in the previous embodiment may not be required.

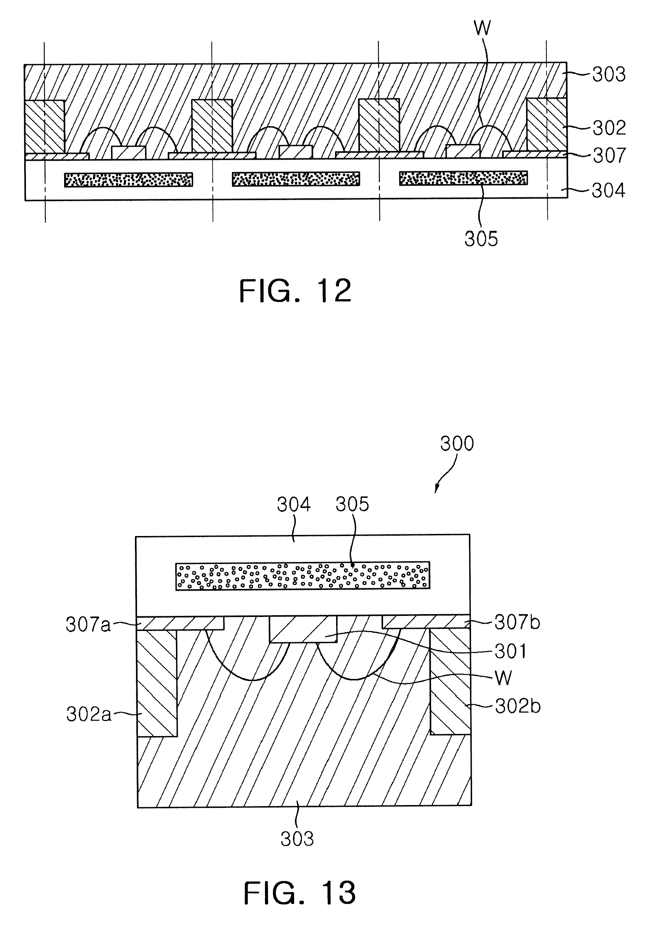

Next, as shown in FIG. 10, a plurality of light emitting devices 301 are arranged on a carrier sheet 308, and conductive wires W, external terminals 302 and connection parts 307 making connections therebetween are formed. In a case in which the conductive wires W and the external terminals 302 are directly connected to each other, the connection parts 307 may not be required. Then, as shown in FIG. 11, a package body 303 is formed to cover the light emitting devices 301. Thereafter, as shown in FIG. 12, the sealing part 304 having the wavelength conversion part 305 therein is attached to the package body 303 to be disposed in a path of light emitted from the light emitting devices 301. After the attachment of the sealing part 304, a dicing process is performed to divide the light emitting devices 301 into package units. Individual light emitting device packages 300 are obtained as shown in FIG. 13. Here, the individual light emitting device packages 300 may have a pair of external terminals 302a and 302b and a pair of connection parts 307a and 307b.

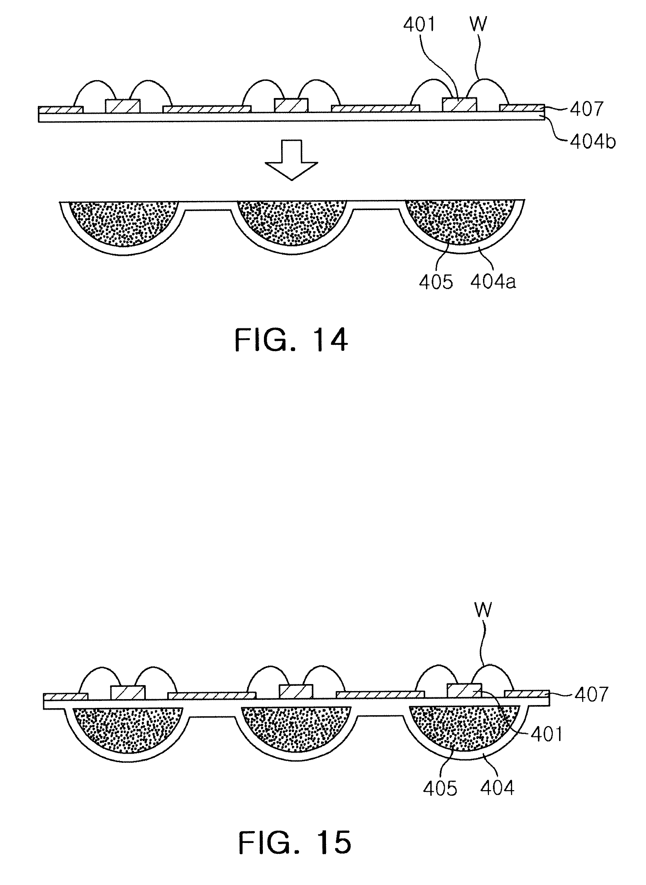

FIGS. 14 through 17 are schematic cross-sectional views illustrating a method of manufacturing a light emitting device package according to another embodiment of the present invention. In the present embodiment, as shown in FIG. 14, light emitting devices 401 are directly disposed on a portion of a sealing part 404, thereby achieving process simplification. Specifically, a wavelength conversion part 405 is formed in a first transparent portion 404a and a second transparent portion 404b is then pressed thereto to thereby form the sealing part 404, which is similar to the method described in the previous embodiment; however, the light emitting devices 401 and elements applying an electrical signal thereto, i.e., conductive wires W and connection parts 407 are directly formed on the second transparent portion 404b. In this case, the sealing part 404 may have a convex lens shape, as shown in FIG. 14, or another shape such as a rectangular parallelepiped shape.

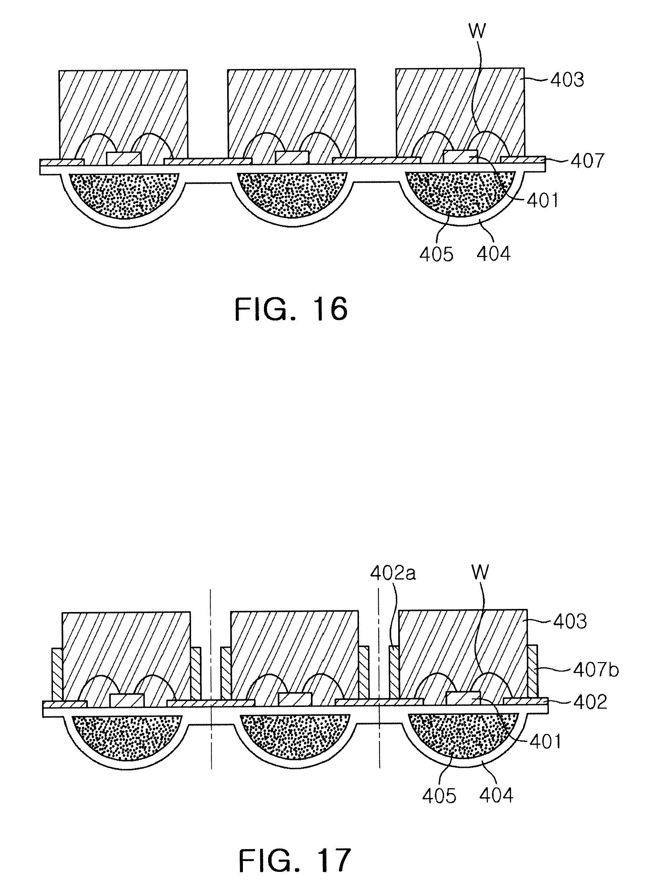

Meanwhile, in FIG. 14, after the light emitting devices 401 are disposed on the second transparent portion 404b, the wavelength conversion part 405 is sealed thereby. However, the sealing process may be previously performed before the light emitting devices 401 are disposed on the second transparent portion 404b. In this manner, the sealing part 404 and the light emitting devices 401 are combined as shown in FIG. 15. Next, as shown in FIG. 16, package bodies 403 are formed. In the present embodiment, the package bodies 403 are separately formed for the respective light emitting devices 401. However, the invention is not limited thereto. As described in the previous embodiment, the package body may be integrally formed as a single piece for the entirety of the individual light emitting devices 401 and then be divided into package units by a subsequent dicing process. Then, as shown in FIG. 17, external terminals 407 are formed on surfaces of the package bodies 403 and the dicing process is performed to divide the light emitting devices 401 into package units, and thus individual light emitting device packages are formed. In a different manner to FIG. 17, the external terminals 407 may be formed after the dicing process, and the external terminals 407 may be extended to other surfaces of the package bodies 403 as well as side surfaces thereof.

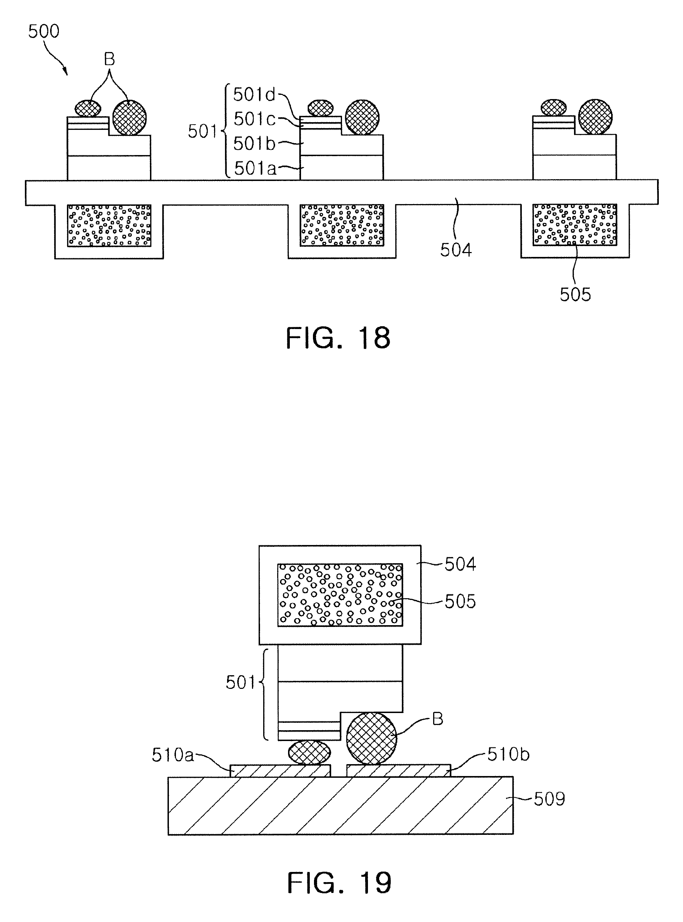

FIGS. 18 through 20 are schematic cross-sectional views of light emitting device packages according to another embodiment of the present invention. In the embodiment of FIG. 18, a sealing part 504 is disposed on at least one surface of a light emitting device 501 provided in a path of light emitted therefrom, and a wavelength conversion part 505 having a quantum dot is sealed within the sealing part 504 as described above. The light emitting device 501 may have a light emitting diode structure in which a board 501a, a first conductivity type semiconductor layer 501b, an active layer 501c, and a second conductivity type semiconductor layer 501d are stacked. A pair of electrodes are disposed on the light emitting device 501 in a direction opposed to the sealing part 504. As shown in FIG. 18, the pair of electrodes may be bump balls B. A light emitting device package 500 in the present embodiment, as shown in FIG. 19, may be mounted on a board 509 by flip-chip bonding and light emitted from the light emitting device 501 may pass through the wavelength conversion part 505 and be discharged outwardly. The pair of bump balls B are connected to wiring patterns 510a and 510b formed on the board 509. Here, the light emitting device package may be mounted on the board 509 in a state in which the structure of FIG. 18 is divided into package units as shown in FIG. 19 or the structure as shown in FIG. 18 is not divided.

A light emitting device package 600 of FIG. 20 includes a plurality of light emitting devices 601, and a sealing part 604 and a wavelength conversion part 605 are integrally formed as a single piece with respect to the plurality of light emitting devices 601. The individual light emitting devices 601 may have a pair of electrodes, for example, a pair of bump balls B. The bump balls B may be connected to external terminals 602 separately formed on a surface of a package body 603. Here, the bump balls B and the external terminals 602 may be appropriately disposed in consideration of connections between the light emitting devices 601 (series connection, parallel connection or a combination thereof). FIG. 20 shows that the light emitting devices 601 are connected to each other in series. Meanwhile, the package body 603 is formed to cover the remaining surfaces of the light emitting devices 601 except for the surface thereof to which the sealing part 604 is attached. The package body 603 may include a light reflective material reflecting light emitted from the light emitting devices 601 in a direction in which the sealing part 604 is disposed.

As described in the present embodiment, the sealing part 604 and the wavelength conversion part 605 are integrally formed as a single piece with respect to the plurality of light emitting devices 601 such that the color coordinates of light emitted from the entirety of the light emitting device package 600 may be uniform. When quantum dots emitting light of different colors are mixed, variations in the mixing ratio thereof may lead to an observer seeing light having different wavelengths. In order to avoid this, a mixing process should be performed in an exact ratio and with exact concentrations. In the mixing process, light emission efficiency as well as the concentration of the quantum dots should be taken into consideration. In the case of a white light source using individual light emitting device packages provided in an array form, each package having quantum dots mixed with a molding resin, there are limitations in adjusting the concentration, uniformity and mixing ratio of the quantum dots, and so, variations in color coordinates between the light emitting device packages may occur. In the light emitting device package 600 of the present embodiment, however, the integrally formed sealing part and wavelength conversion part 604 and 605 are prepared separately with respect to the light emitting devices 601, whereby uniform color coordinates may be obtained throughout the entirety of the light emitting device package 600.

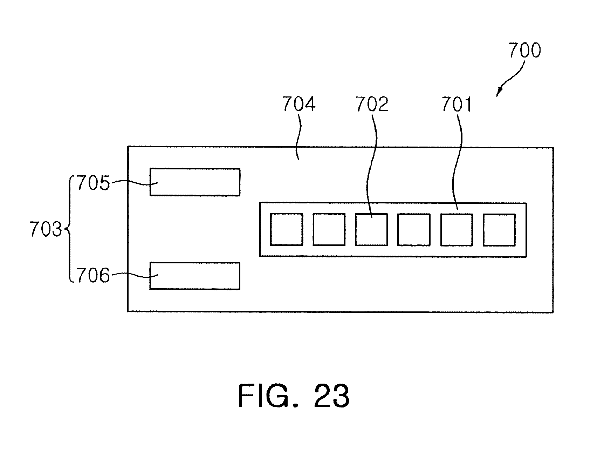

FIG. 23 is a schematic view illustrating an example of the configuration of a light emitting device package according to an embodiment of the present invention. With reference to FIG. 23, an illumination apparatus 700 may include a light emitting module 701, a structure 704 having the light emitting module 701 disposed therein, and a power supply unit 703. The light emitting module 701 may have at least one light emitting device package 702 obtained by the methods proposed in the preceding embodiments. The power supply unit 703 may include an interface 705 receiving power and a power controlling part 706 controlling power supply to the light emitting module 701. Here, the interface 705 may include a fuse blocking over current and an electromagnetic interference (EMI) filter blocking EMI signals.

When the power controlling part 706 receives AC power as an input power, the power controlling part 706 may have a rectifying portion converting AC power into DC power, and a constant voltage controlling portion converting the DC power into a voltage suitable for the light emitting module 701. If the power supply unit may be a DC power source, such as a cell/battery, having a voltage suitable for the light emitting module 701, the rectifying portion and the constant voltage controlling portion may be omitted. In a case in which an AC-LED device is employed as the light emitting module 701, AC power may be directly supplied to the light emitting module 701. In this case, the rectifying portion and the constant voltage controlling portion may be omitted. In addition, the power controlling part may control color temperature or the like such that a variety of illumination levels may be achieved according to human sensitivity. Also, the power supply unit 703 may include a feedback circuit comparing the amount of light emitted from the light emitting device packages 702 with a predetermined amount of light and a memory storing information regarding desired brightness or color rendering properties.

The illumination apparatus 700 may be used as a backlight unit or a lamp used in a display device such as a liquid crystal display (LCD) device having a display panel, an interior illumination apparatus such as a flat panel lighting device or the like, and an outdoor illumination apparatus such as a street light, an electric sign or the like. The illumination apparatus 700 may also be used in a variety of lighting devices for a vehicle such as a car, a ship, an airplane or the like. Furthermore, the illumination apparatus 700 may be used in home appliances such as a TV, a refrigerator and the like, as well as in medical equipment, and the like.

As set forth above, according to embodiments of the invention, a light emitting device package uses a quantum dot as a wavelength conversion part to thereby achieve superior color reproducibility and light emission efficiency, and facilitates the control of color coordinates by adjusting the particle size and concentration of the quantum dot. An organic solvent or a polymer having the quantum dot dispersed therein is sealed within a sealing part to thereby block the influence of oxygen or moisture. Accordingly, a light emitting module can be stably operated even in a high temperature atmosphere, or in high temperature and high humidity conditions.

In addition, such a light emitting device package is used in an illumination apparatus, a display apparatus or the like, whereby the reliability and efficiency of the apparatus can be enhanced.

While the present invention has been shown and described in connection with the embodiments, it will be apparent to those skilled in the art that modifications and variations can be made without departing from the spirit and scope of the invention as defined by the appended claims.

## Claims

1. A light emitting device package comprising:
a light emitting device;
a sealing part disposed in a path of light emitted from the light emitting device and having a lens shape; and
a wavelength conversion part sealed within the sealing part and including a quantum dot.

2. The light emitting device package of claim 1, wherein the sealing part has an outer surface and an inner surface facing the light emitting device,
wherein the outer and inner surfaces have a convex shape towards an upper part of the light emitting device.

3. The light emitting device package of claim 2, wherein the light emitting device is disposed to be enclosed by the inner surface having the convex shape.

4. The light emitting device package of claim 3, further comprising a transparent encapsulation part filling a space defined by the inner surface of the sealing part.

5. The light emitting device package of claim 1, further comprising a pair of lead frames,
wherein one of the pair of lead frames is provided as a mounting area for the light emitting device.

6. The light emitting device package of claim 5, further comprising a pair of conductive wires electrically connecting the light emitting device to the pair of lead frames,
wherein the pair of conductive wires are disposed to be enclosed by the inner surface having the convex shape.

7. The light emitting device package of claim 1, further comprising a package body providing a mounting area for the light emitting device and reflecting the light emitted from the light emitting device in a direction in which the sealing part is disposed.

8. The light emitting device package of claim 7, wherein the package body includes:
a transparent resin; and
light reflective particles dispersed in the transparent resin.

9. The light emitting device package of claim 7, further comprising a conductive wire transferring an electrical signal to the light emitting device,
wherein a portion of the conductive wire is disposed within the package body.

10. The light emitting device package of claim 7, further comprising a pair of external terminals extending from side surfaces of the package body to a lower surface thereof and electrically connected to the light emitting device.

11. The light emitting device package of claim 1, wherein the sealing part is formed of a glass or polymer material.

12. The light emitting device package of claim 1, wherein the wavelength conversion part further includes an organic solvent or a polymer resin having the quantum dot dispersed therein.

13. The light emitting device package of claim 1, wherein the light emitting device emits blue light, and
the quantum dot includes a first quantum dot having a peak wavelength within a green light wavelength band and a second quantum dot having a peak wavelength within a red light wavelength band.

14. The light emitting device package of claim 13, wherein the light emitted from the light emitting device has a wavelength of 435 nm to 470 nm,
green light emitted from the first quantum dot has a color coordinate falling within a region defined by four coordinate points (0.1270, 0.8037), (0.4117, 0.5861), (0.4197, 0.5316) and (0.2555, 0.5030) based on the CIE 1931 chromaticity diagram, and
red light emitted from the second quantum dot has a color coordinate falling within a region defined by four coordinate points (0.5448, 0.4544), (0.7200, 0.2800), (0.6427, 0.2905) and (0.4794, 0.4633) based on the CIE 1931 chromaticity diagram.

15. The light emitting device package of claim 14, wherein green light emitted from the first quantum dot has a color coordinate falling within a region defined by four coordinate points (0.1270, 0.8037), (0.3700, 0.6180), (0.3700, 0.5800) and (0.2500, 0.5500) based on the CIE 1931 chromaticity diagram, and
red light emitted from the second quantum dot has a color coordinate falling within a region defined by four coordinate points (0.6000, 0.4000), (0.7200, 0.2800), (0.6427, 0.2905) and (0.6000, 0.4000) based on the CIE 1931 chromaticity diagram.

16. The light emitting device package of claim 13, wherein the light emitted from the light emitting device has a full-width half-maximum of 10 nm to 30 nm,
light emitted from the first quantum dot has a full-width half-maximum of 10 nm to 60 nm, and
light emitted from the second quantum dot has a full-width half-maximum of 30 nm to 80 nm.
